# EUROPÄISCHE PATENTSCHRIFT

(11) **EP 1 584 905 B1**
(45) Veröffentlichungstag und Bekanntmachung des Hinweises auf die Patenterteilung: **14.11.2018**
(21) Anmeldenummer: 05102201.0
(22) Anmeldetag: 18.03.2005
(51) Int. Cl.: G01J 9/00

(54) **Signalverarbeitungselektronik**
Electronic device for processing signals
Dispositif électronique pour le traitement de signaux

(30) Priorität: 05.04.2004 DE 102004016626
(43) Veröffentlichungstag der Anmeldung: 12.10.2005
(73) Patentinhaber: pmdtechnologies ag, 57076 Siegen (DE)
(72) Erfinder: XU, Zhanping, 57250, Netphen (DE); KRAFT, Holger, 57078, Siegen (DE); MÖLLER, Tobias, 36137, Grossenlüder (DE); FREY, Jochen, 35578, Wetzlar (DE)
(74) Vertreter: WSL Patentanwälte Partnerschaft mbB

(56) Entgegenhaltungen:
- WO-A-02/33922
- WO-A-99/60629
- WO-A-2004/027357

## Beschreibung

Die vorliegende Erfindung betrifft ein Verfahren und eine elektronische Schaltung zur Verarbeitung zweier zumindest teilweise korrelierter Ausgangssignalströme eines Mischers, wobei der Mischer mindestens zwei Signaleingänge und mindestens zwei elektrische Signalausgänge aufweist.

Aus dem Stand der Technik sind elektronische und optoelektronische Mischerbauelemente bekannt, die es ermöglichen, zwei oder mehr elektrische und optische bzw. elektromagnetische Signale miteinander zu mischen und ein elektrisches Mischsignal auszugeben.

Typischerweise sind die mindestens zwei Eingangssignale des Mischers miteinander korreliert. Weisen die beiden Eingangssignale die gleiche Modulationsfrequenz auf, so spricht man von einer homodynen Signalmischung. Bestehen die zu mischenden Signale ausschließlich aus korrelierten Signalanteilen, so erhält man als Ergebnis des Mischprozesses an den Ausgängen des Mischers Ausgangssignale, die ausschließlich zueinander korrelierte Signalbestandteile aufweisen.

Häufig ist es aber der Fall, daß eines oder mehrere der Eingangssignale neben den korrelierten Signalbestandteilen auch unkorrelierte Bestandteile aufweisen. Signalanteile, die in nur einem oder einem Teil eines Eingangssignals auftreten, also nicht mit den Anteilen der anderen Eingangssignale korreliert sind, führen zu nicht-korrelierten Signalbeiträgen in den Ausgangssignalen des Mischers.

Die Amplituden der nicht-korretierten Signalanteile der Ausgangssignale liegen häufig in der gleichen Größenordnung oder sie sind sogar größer als die korrelierten Signalanteile. Daher beschränken die nicht-korrelierten Signalanteile auf den Ausgangssignalen häufig den dynamischen Bereich der nachgeschalteten Signalverarbeitungseinheit. In manchen extremen Fällen können die unkorrelierten Signalanteile sogar zu einer Ausschöpfung des dynamischen Bereichs der Signalverarbeitungseinheit führen, so daß eine Weiterverarbeitung der korrelierten Mischersignale nicht mehr möglich ist.

Die WO 02/33922 A2 offenbart ein Verfahren zur Erfassung und Verarbeitung der Amplitude und Phase von Signalwellen, wobei eine Signalquelle eine modulierte Signalwelle erzeugt, die auf ihrem Weg durch ein Übertragungsmedium bzw. durch ein Objekt aufgrund von Reflexion und/oder Streuung verändert, von einer Empfangseinrichtung empfangen und dort mit einem Modulationssignal, das in einer wohldefinierten Beziehung zu der Modulation der Signalwelle steht, durch eine Modulationsvorrichtung ohne den Träger der Signalwelle direkt demoduliert und bezüglich der Amplitude der modulierten Signalwelle und der Phasenbeziehung der Modulationsphase der Signalwelle und des Modulationssignals erfasst und ausgewertet wird, wobei die Differenz der Signalspannungen zweier Ausleseausgänge der Empfangseinrichtung in einer Auswerteschaltung mit Hilfe eines Differenzverstärkers gebildet wird.

Aus dem Stand der Technik sind keine Verfahren oder Vorrichtungen bekannt, mit denen die unkorrelierten Signalanteile verzögerungsfrei von den korrelierten Signalanteilen der Ausgangs-signalströme eines Mischers getrennt werden können.

Gegenüber diesem Stand der Technik liegt der vorliegenden Erfindung die Aufgabe zugrunde, ein Verfahren und eine Vorrichtung bzw. eine elektronische Schaltung zur Verfügung zu stellen, die es ermöglicht, die korrelierten Signalanteile der Ausgangssignale eines Mischers von den unkorrelierten Signalanteilen ohne Verzögerung zu trennen.

Diese Aufgabe wird erfindungsgemäß dadurch gelöst, daß ein Verfahren zur Verarbeitung mindestens zweier zumindest teilweise korrelierter Ausgangssignalströme eines Mischers bereitgestellt wird, wobei der Mischer mindestens zwei Signaleingänge und mindestens zwei elektrische Signalausgänge aufweist und wobei paarweise die Differenz der Ausgangssignalströme des Mischers unmittelbar und während des Auslesens der Ausgangssignalströme gebildet wird, wobei der Signalstrom eines ersten Mischerausgangs mit Hilfe eines Reglers in ein vom Signalstrom abhängiges Spannungssignal umgewandelt wird und nachfolgend das Spannungssignal mit Hilfe eines Spannungs/Strom-Wandlers in mindestens ein vom Spannungssignal abhängiges Stromsignal umgewandelt wird, wobei das mindestens eine Stromsignal zum Signalstrom invertiert ist und wobei eines der Stromsignale zusammen mit dem Signalstrom eines zweiten Mischerausgangs auf einen ersten Summationspunkt gegeben wird.

Eine solche Ausgestaltung eines Verfahrens zur Verarbeitung mindestens zweier zumindest teilweise korrelierter Ausgangssignalströme eines Mischers ist vorteilhaft, da bei der paarweisen Differenzbildung zwischen den Ausgangssignalströmen des Mischers nur die korrelierten Signalanteile einen Beitrag zum Differenzsignal liefern. So wird eine effektive Abtrennung der nicht-korrelierten Signalbestandteile von dem Ausgangssignal bzw. den Ausgangssignalen des Mischers erreicht.

Das bei der Differenzbildung erhaltene Signal ist gleich dem doppelten korrelierten Signalanteil eines Signalstromes des Mischers. Damit kann der gesamte Dynamikbereich der Signalverarbeitungseinheit für die Verarbeitung der korrelierten Signale genutzt werden. Dabei erfolgt die Unterdrückung der unkorrelierten Signalbestandteile über eine große Signalbandbreite hinweg äußerst wirksam.

Ein weiterer Vorteil des erfindungsgemäßen Verfahrens ist, daß es auf sämtliche Mischer mit zwei Ausgängen und Vielfachen von zwei Ausgängen angewandt werden kann.

Gemäß der vorliegenden Erfindung erfolgt bei der Signalverarbeitung die Bildung des Differenzsignals zwischen jeweils zwei Ausgängen des Mischers instantan, d.h. in Echtzeit, und ohne eine vorherige Signalintegration oder eine Mehrfachabtastung zu erfordern.

Das beschriebene Verfahren zur Verarbeitung des Ausgangssignals kann sowohl für rein elektronische Mischer verwendet werden, bei denen die Eingangssignale des Mischers elektrische Signale sind, als auch für optoelektronische Mischer, bei denen mindestens eines der Eingangssignale des Mischers ein optisches bzw. elektromagnetisches Signal ist.

Ein Beispiel für solche Mischer sind Schottky-Diodenempfänger, wie sie in der HochfrequenzTechnik verwendet werden.

Ein Beispiel für solche Mischer sind Schottky-Diodenempfänger, wie sie in der HochfrequenzTechnik verwendet werden.

Ein weiteres Beispiel für einen solchen optoelektronischen Mischer sind die sogenannten Photomischdetektoren (Photonic Mixer Devices, kurz PMD), so wie sie in der deutschen Offenlegungsschrift DE 198 21 974 A1 offenbart werden. Der Offenbarungsgehalt dieser Druckschrift wird hier durch Bezugnahme vollständig in die vorliegende Anmeldung aufgenommen.

Ein solcher Photomischdetektor weist ein photoleitendes Material auf, in dem die einfallende elektromagnetische Strahlung Ladungsträger erzeugt. Diese photogenerierten Ladungsträger werden in einem an die Modulationsgates des Photomischdetektors angelegten elektrischen Feld bewegt. Der fließende Strom wird gemessen. Dabei kann die Strom- bzw. Spannungsmessung sowohl an den Modulationsgates selbst erfolgen als auch an zusätzlichen Ausleseelektroden bzw. -gates. Bei dem aus dem Stand der Technik bekannten Meßverfahren zur Bestimmung der Phase und Amplitude der einfallenden intensitätsmodulierten elektromagnetischen Strahlung ist es notwendig, die Modulationsgates des Photomischdetektors mit einem oder auch zwei um 180° phasenverschobenen amplitudenmodulierten Spannungssignalen zu versorgen, welche mit der Intensitätsmodulation der einfallenden elektromagnetischen Strahlung korreliert sind. Dabei bedeutet Korrelation im einfachsten Fall, daß die Amplituden- bzw. Intensitätsmodulationen der Vorspannung des Photomischdetektors und der elektromagnetischen Strahlung den gleichen zeitlichen Verlauf haben. Dies wird auch als starre Phasenkopplung zwischen dem optischen und dem elektrischen Signal bezeichnet. Daher kann das elektrische Signal auch als Referenzsignal bezeichnet werden. Das über die Ausleseelektroden gemessene Spannungs- oder Stromsignal ist eine Funktion des Produktes aus der Anzahl generierten Ladungsträgern und der Modulations- bzw. Referenzspannung. Daher ist das gemessene Signal eine Funktion der Intensität der einfallenden elektromagnetischen Welle und der Phasendifferenz zwischen der elektromagnetischen Welle und dem elektrischen Referenzsignal. Werden mit zwei benachbarten Photomischdetektoren gleichzeitig die Quadraturkomponenten des einfallenden Signals gemessen, so erhält man unmittelbar die Phasendifferenz zwischen der elektromagnetischen Welle und dem elektrischen Referenzsignal. Die Quadraturkomponenten können jedoch auch mit einem einzelnen Photomischdetektor zeitlich nacheinander gemessen werden, wenn zwischen den beiden Messungen die Phase des Referenzsignals um 90° verschoben wird.

Besonders bevorzugt wird dabei eine Ausführungsform der Erfindung, bei der die Ausleseelektroden des Mischers Dioden sind. Solche Mischer weisen an jeder Ausleseelektrode nur eine Stromrichtung auf, welche für alle Ausleseelektroden gleich ist. Daher ist auf sie das erfindungsgemäße Verfahren besonders vorteilhaft anwendbar.

Um die paarweise Differenz zweier Ausgänge des Mischers unmittelbar während des Auslesens zu erzeugen, wird der Signalstrom einer der Ausgänge des Mischers invertiert bzw. gespiegelt und kann dann direkt mit dem Signal des zweiten Ausganges auf einen gemeinsamen Summationspunkt gegeben werden.

Besonders bevorzugt wird dabei eine Ausführungsform der vorliegenden Erfindung, bei der die Amplitude des Signalstroms eines ersten Ausgangs des Mischers gemessen wird. Betrachtet man den zuvor beschriebenen Photomischdetektor, so wird die Amplitude des Signalstroms einer der Ausleseelektroden des Detektors gemessen.

Um die Differenz zwischen dem Signalstrom des ersten Ausgangs des Mischers und dem Signalstrom des zweiten Ausgangs des Mischers bilden zu können, wird der Signalstrom des ersten Ausgangs in ein Spannungssignal umgewandelt, welches eine Funktion des Signalstroms ist. Dabei erfolgt die Umwandlung des Signalstroms in ein Spannungssignal mit Hilfe eines Reglers. Die Amplitude des Spannungssignals wird mit Hilfe einer an den Spannungseingang des Reglers angelegten Steuerspannung geregelt.

Nachfolgend wird das Spannungssignal mit Hilfe eines Spannungs/Strom-Wandlers in ein Stromsignal umgewandelt, welches wiederum eine Funktion des Spannungssignals ist. Das umgewandelte Stromsignal hinter dem Spannungs/Strom-Wandler weist ein dem Signalstrom des zweiten Mischerausgangs entgegengesetztes Vorzeichen auf. Zweckmäßigerweise ist die Spannungs/Strom-Wandlerkennlinie über einen Steuereingang beeinflußbar.

Besonders bevorzugt wird dabei eine Regelung des Reglers und des Spannungs/Strom-Wandlers, bei der der Signalstrom des ersten Mischerausgangs und das umgewandelte Stromsignal hinter dem Spannungs/Strom-Wandler den gleichen Betrag haben. So werden die unkorrelierten Signalanteile vollständig unterdrückt. Jedoch sind auch andere Grade der Signalunterdrückung einstellbar.

Der Signalstrom des zweiten Mischerausgangs und das umgewandelte Stromsignal oder der invertierte Signalstrom des ersten Mischerausgangs werden auf einen ersten Summationspunkt gegeben. Der über den dritten Anschluß des Summationspunkts fließende Strom entspricht nun der Differenz zwischen den beiden zumindest teilweise korrelierten Signalströmen des ersten und des zweiten Mischerausgangs. Dabei ist das Differenzsignal gleich zweimal dem korrelierten Signalanteil eines Mischerausgangs. Dieses Differenzverfahren zur Abtrennung der korrelierten von den nicht-korrelierten Signalanteilen ist auch deshalb vorteilhaft, weil es gegenüber Unsymmetrien in den beiden Signalpfaden, so wie sie beispielsweise aufgrund der Herstellungstechnologie am Mischer auftreten können, weitgehend unempfindlich ist.

Dabei ist es zweckmäßig, wenn die Differenz der Signalströme hinter dem Summationspunkt zu einem Spannungssignal aufintegriert wird.

In einer besonders bevorzugten Ausführungsform der Erfindung wird das Differenzsignal in einer Signalverarbeitungseinheit hinter dem Summationspunkt bzw. dem Integrator weiter verarbeitet.

Vorteilhaft ist es, wenn zwei vom Spannungssignal des ersten Mischerausgangs abhängige Stromsignale erzeugt werden. Dies kann beispielsweise durch einen zweiten Ausgang an dem Spannungs/Strom-Wandler erfolgen oder durch einen zusätzlichen Replikator hinter dem Spannungs/Strom-Wandler. Dabei ist darauf zu achten, daß beide so erzeugten Stromsignale die gleiche Amplitude aufweisen. Integriert man nun eines der beiden Stromsignale auf, ohne es auf den ersten Summationspunkt zu geben, so erhält man ein Spannungssignal, das eine Funktion der Summe aus korrelierten und unkorrelierten Signalanteilen ist. Dieses Signal kann beispielsweise für die Regelungen des Mischersystems verwendet werden.

In einer besonders bevorzugten Ausführungsform der Erfindung wird zusätzlich zur Differenz der Signalströme der beiden Mischerausgänge die Summe der beiden Signalströme gebildet.

Dazu ist es zweckmäßig, wenn die Stromsignale des ersten und des zweiten Mischerausgangs repliziert werden. Jeweils einer der replizierten Signalströme eines jeweiligen Mischerausgangs wird auf einen zweiten Summationspunkt gegeben. Da die beiden Signalströme auf dem zweiten Summationspunkt das gleiche Vorzeichen aufweisen, wird hier direkt die Summe der beiden Signalströme gebildet. Wird das Summensignal ferner hinter dem zweiten Summationspunkt aufintegriert, so erhält man ein Spannungssignal, das gleich der Summe der beiden Signalströme hinter dem Summationspunkt ist.

Bei der Summenbildung heben sich die Beiträge der korrelierten Signalanteile der beiden Signalströme gegenseitig auf, während das Summensignal dem Doppelten des nicht-korrelierten Signalbeitrags eines der Signalströme entspricht.

Bezüglich der Vorrichtung wird die Aufgabe dadurch gelöst, daß eine elektronische Schaltung zur Verarbeitung mindestens zweier zumindest teilweise korrelierter Ausgangssignalströme eines Mischers bereitgestellt wird, wobei der Mischer mindestens zwei Signaleingänge und zwei elektrische Signalausgänge aufweist und wobei die Schaltung eine Einrichtung zur Bildung der paarweisen Differenz zwischen den Ausgangssignalströmen und einen Invertierer für einen Signalstrom eines ersten Mischerausgangs aufweist, wobei der Invertierer einen Regler zum Umwandeln des Signalstroms des ersten Mischerausgangs in ein vom Signalstrom abhängiges Spannungssignal und einen Spannungs/Strom-Wandler zum Umwandeln des Spannungssignals in mindestens ein vom Spannungssignal abhängiges Stromsignal aufweist, wobei das mindestens eine Stromsignal zum Signalstrom invertiert ist und wobei der Ausgang des Invertierers und ein zweiter Mischerausgang mit einem ersten Summationspunkt verbunden sind.

Besonders bevorzugt wird dabei eine Ausführungsform der Erfindung, bei der die Ausleseelektroden des Mischers Dioden sind. Solche Mischer weisen an jeder Ausleseelektrode nur eine Stromrichtung auf, welche für alle Ausleseelektroden gleich ist. Daher ist ein solcher Mischer mit der erfindungsgemäßen Vorrichtung besonders vorteilhaft betreibbar.

Die erfindungsgemäße elektronische Schaltung weist eine Einrichtung zum Invertieren des Stromsignals eines ersten Mischerausgangs auf, wobei die Einrichtung zum Invertieren mit einem ersten Mischerausgang verbunden ist.

Die Einrichtung zum Invertieren weist eine Einrichtung zum Umwandeln des Signalstroms des ersten Ausgangs in ein vom Signalstrom abhängiges Spannungssignal auf, wobei die Einrichtung zum Umwandeln mit dem ersten Ausgang des Mischers verbunden ist. Dabei kann die Einrichtung zum Umwandeln des Signalstroms in ein vom Signalstrom abhängiges Spannungssignal ein Reglerbauelement sein, dessen Kennlinie von der am Spannungseingang anliegenden Spannung beeinflußbar ist. Zur Erzeugung eines invertierten Stromsignals ist ein Spannungs/Strom-Wandler vorgesehen, der das Spannungssignal in ein vom Spannungssignal abhängiges Stromsignal umwandelt. Dabei ist es zweckmäßig, wenn die Spännungs/Strom-Wandlerkennlinie des Spannungs/Strom-Wandlers regelbar ist.

Der Ausgang des Spannungs/Strom-Wandlers und der zweite Ausgang des Mischers sind mit einem Summationspunkt verbunden, so daß über den dritten Anschluß des Summationspunkts ein Strom fließt, welcher der Differenz der beiden Signalströme entspricht.

Dabei ist es zweckmäßig, wenn hinter dem Summationspunkt ein Integrator zum Aufintegrieren der Differenz der Ströme zu einem Spannungssignal vorgesehen ist.

Besonders bevorzugt wird eine Ausführungsform der Erfindung, bei der der Spannungs/StromWandler zwei Ausgänge aufweist, die ein zum Signalstrom des ersten Ausgangs des Mischers proportionales invertiertes Stromsignal ausgeben.

Alternativ dazu kann mit dem Ausgang des Spannungs/Strom-Wandlers ein Stromreplikator verbunden sein.

Dabei ist es zweckmäßig, wenn hinter dem einen Ausgang des Spannungs/Strom-Wandlers bzw. dem Stromreplikator ein Integrator vorgesehen ist, der eines der beiden Stromsignale zu einem Spannungssignal aufintegriert. Dieses integrierte Spannungssignal ist eine Funktion der korrelierten und nicht-korrelierten Signalanteile des ersten Signalstroms.

In einer besonders bevorzugten Ausführungsform der Erfindung ist zusätzlich eine Vorrichtung zur Erzeugung der Summe der Signalströme der beiden Mischerausgänge vorgesehen.

Eine solche Vorrichtung kann durch Replikatoren hinter den Mischerausgängen zum Erzeugen von jeweils zwei identischen Stromsignalen der Mischerausgänge realisiert werden. Jeweils eines der beiden Stromsignale eines jeden Mischerausgangs ist mit einem zweiten Summationspunkt verbunden. Der dritte Anschluß des Summationspunkts ist mit einem Integrator verbunden, welcher das Summenstromsignal zu einem Spannungssignal aufintegriert.

Besonders bevorzugt wird eine Ausführungsform der vorliegenden Erfindung, bei der die elektronische Schaltung ein integrierter Schaltkreis ist. Dabei kann der integrierte Schaltkreis beispielsweise in bekannter Siliziumtechnologie hergestellt sein. Es ist zweckmäßig, wenn die elektronische Schaltung mit den elektronischen oder optoelektronischen Mischerelementen auf einem Bauelement integriert ist. Dabei können auch mehrere Mischerelemente mit jeweils einer elektronischen Schaltung zur Differenz- und Summenbildung in einem Bauelement integriert sein. So läßt sich ein hochintegriertes elektronisches Bauelement herstellen, das eine zweidimensionale Anordnung von Mischern, z.B. zur Erfassung eines Bildsignals, aufweist. Dabei sind die einzelnen Mischer, welche die Bildpunkte bilden und die zugehörigen Schaltungen zur Summen- und Differenzbildung integriert.

Weitere Merkmale, Vorzüge und Anwendungen der vorliegenden Erfindung werden anhand der folgenden Beschreibung bevorzugter Ausführungsformen und der zugehörigen Figuren deutlich.
- Figur 1: zeigt einen schematischen Schaltungsaufbau einer ersten Ausführungsform der Erfindung.
- Figur 2: zeigt eine schematische Ansicht eines Photomischdetektors.
- Figur 3: zeigt einen schematischen Schaltungsaufbau einer zweiten Ausführungsform der Erfindung.
- Figur 4: zeigt einen schematischen Schaltungsaufbau einer weiteren Ausführungsform der Erfindung.

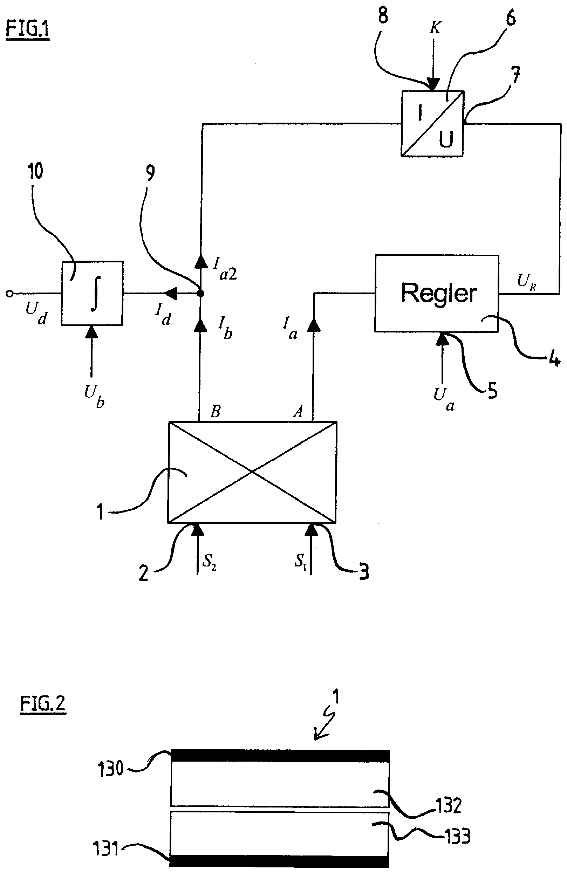

In Figur 1 ist ein schematischer Aufbau einer erfindungsgemäßen Schaltungsanordnung dargestellt. In der gezeigten Ausführungsform weist der Mischer 1 zwei Signaleingänge 2, 3 und zwei Signalausgänge A, B auf.

In der dargestellten Ausführungsform ist das Eingangssignal S1 ein elektrisches Referenzsignal, während das Eingangssignal S2 eine elektromagnetische Welle ist.

Aus diesem Grund ist der Mischer 1 als Photomischdetektor ausgestaltet, so wie er in Figur 2 dargestellt ist. Dieser weist eine photoempfindliche Schicht für das Signal S1 auf und zwei Modulationsgates 132, 133 für das elektrische Referenzsignal S2. Dabei werden die beiden Modulationsgates 132, 133 des Mischers 1 mit um 180° gegeneinander phasenverschobenen Signalen des elektrischen Referenzsignals S2 versorgt. Die Modulationsgates 132, 133 sind für die einfallende elektromagnetische Strahlung S1 transparente Gates, die über der photoempfindlichen Schicht angeordnet sind. Der Photomischdetektor weist weiterhin zwei Ausleseelektroden 130, 131 auf, die den Modulationsgates benachbart angeordnet sind und in elektrischem Kontakt mit der photoleitenden Schicht sind. Dabei haben die Ausleselektroden 130, 131 des Photomischdetektors in der dargestellten Ausführungsform die Strom-Spannungs-Kennlinie einer Diode. Die Ausleseelektroden 130, 131 des Photomischdetektors 1 bilden die Signalausgänge A und B des Mischers 1.

In einer alternativen Ausführungsform können die Ausleseelektroden 130, 131 des Photomischdetektors gleichzeitig mit dem elektrischen Referenzsignal S2 versorgt werden, so daß die Modulationsgates 132, 133 entfallen. In diesem Fall ist der Eingang 2 des Referenzsignals S2 mit den Signalausgängen A und B des Mischers 1 identisch.

Zum Verständnis der in Figur 1 dargestellten Schaltung wird zunächst der Signalstrom Iₐ des Mischerausgangs A verfolgt. Der Signalstrom Iₐ wird auf einen Regler 4 gegeben, der den Signalstrom Iₐ in ein davon abhängiges Spannungssignal U_{R} umsetzt. Dabei ist die Kennlinie des Reglers 4 mit Hilfe der am Spannungseingang 5 anliegenden Spannung Uₐ steuerbar. Das vom Regler ausgegebene Spannungssignal U_{R} ist eine Funktion der Amplitude des Signalstroms Iₐ.

Der Ausgang des Reglers 4 ist mit dem Spannungseingang 7 eines Spannungs/Strom-Wandlers 6 verbunden. Dieser setzt das Spannungssignal U_{R} in ein Stromsignal Iₐ₂ um. Das Stromsignal Iₐ₂ ist abhängig von der Eingangsspannung U_{R} des Spannungs/Strom-Wandlers 6 und somit von dem Stromsignal Iₐ des Ausgangs A des Mischers 1. Die Spannungs/Strom-Wandlerkennlinie des Spannungs/Strom-Wandlers 6 ist mit Hilfe des Kennlinieneingangs 8 und einem daran anliegenden Steuersignal K einstellbar.

Über eine geeignete Einstellung der Kennlinien des Reglers 4 und des Spannungs/Strom-Wandlers 6 kann der Strom Iₐ₂ so eingestellt werden, daß er dem Betrag nach gleich dem Signalstrom Iₐ des Ausgangs A des Mischers 1 ist.

Der Stromausgang Iₐ₂ des Spannungs/Strom-Wandlers 6 wird auf einen Summationspunkt 9 gegeben. Ebenfalls mit dem Summationspunkt 9 ist der zweite Signalstrom I_{b} des Ausgangs B des Mischers 1 verbunden. Dabei ist darauf zu achten, daß das Stromsignal Iₐ₂ ein umgekehrtes Vorzeichen wie der Signalstrom I_{b} des Ausgangs B des Mischers 1 aufweist. So ist der Strom, der über den dritten Anschluß des Summationspunkts 9 abfließt, gleich der Differenz zwischen den Strömen I_{b} und Iₐ₂. Dieser Differenzstrom I_{d} ist zweimal so groß wie der korrelierte Signalanteil eines Signalstroms des Mischers 1.

Der vom Summationspunkt 9 abfließende Differenzstrom I_{d} wird mit Hilfe eines Integrators 10 zu einem Spannungssignal U_{d} aufintegriert.

Bei der Bildung der Differenz zwischen den Strömen I_{b} und Iₐ₂ an dem Summationspunkt 9 fallen alle nicht-korrelierten Signalbeiträge weg. So läßt sich eine einfache Abtrennung der korrelierten von den nicht-korrelierten Signalanteilen erreichen. Das an dem Integrator abzugreifende Spannungssignal U_{d} kann daher nachfolgend verarbeitet werden, ohne daß nicht-korrelierte Signalanteile den dynamischen Bereich der nachgeschalteten Auswerteelektronik ausschöpfen.

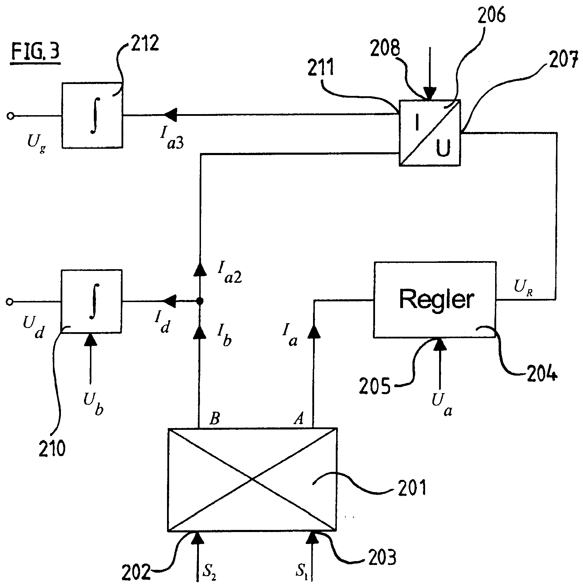

Soll neben dem korrelierten Signalanteil auch eine Information über das gesamte Signal gewonnen werden, so kann eine Schaltung wie in Figur 3 dargestellt, verwendet werden. Der Schaltungsaufbau in Figur 3 unterscheidet sich von der in Figur 1 gezeigten Schaltung durch einen zweiten Ausgang 211 des Spannungs/Strom-Wandlers 206. Das an dem zweiten Ausgang 211 ausgegebene Stromsignal Iₐ₃ ist ebenfalls proportional bzw. gleich dem Betrag des Signalstroms Iₐ des Ausgangs A des Mischers 201. Das Stromsignal Iₐ₃ wird mit Hilfe eines Integrators 212 zu einem Spannungssignal U_{g} aufintegriert, das Informationen sowohl über die korrelierten als auch die nicht-korrelierten Signalanteile enthält.

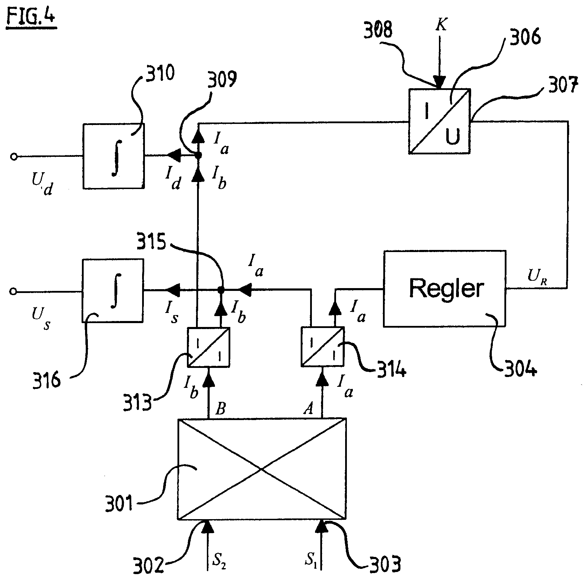

Möchte man hingegen zusätzliche Informationen über die unkorrelierten Signalbestandteile erhalten, so muß die gegenüber der Figur 1 leicht abgewandelte Schaltung aus Figur 4 verwendet werden. In dieser Schaltung sind hinter den Signalausgängen A und B des Mischers 301 Stromreplikatoren 313 und 314 vorgesehen, die den Signalstrom Iₐ bzw. I_{b} an zwei Ausgängen zur Verfügung stellen. Jeweils einer der beiden Ausgänge der Replikatoren 313, 314 wird wie in Figur 1 zum Bilden der Differenz zwischen den beiden Signalströmen Iₐ und I_{b} verwendet. Der jeweils zweite Ausgang der Replikatoren 313, 314 wird auf einen zweiten Summationspunkt 315 gegeben, wobei die beiden Signalströme Iₐ und I_{b} das gleiche Vorzeichen aufweisen. Das von dem zweiten Summationspunkt 315 abfließende Summenstromsignal Iₛ entspricht dann der Summe der Ströme Iₐ und I_{b}, wobei diese Summe die nicht-korrelierten Signalanteile der Signalströme Iₐ und I_{b} aufweist. Integriert man dieses Stromsignal Iₛ mit einem Integrator 316, so erhält man ein Spannungssignal Uₛ, das proportional zur Summe der beiden Signalströme Iₐ, I_{b} des Mischers 301 ist.

## Patentansprüche

1. Verfahren zur Verarbeitung mindestens zweier zumindest teilweise korrelierter Ausgangs-Signalströme eines Mischers, wobei der Mischer mindestens zwei Signaleingänge und mindestens zwei elektrische Signalausgänge aufweist, **dadurch gekennzeichnet, daß** paarweise die Differenz der Signalströme der Ausgänge des Mischers unmittelbar und während des Auslesens der Signalströme gebildet wird, wobei der Signalstrom eines ersten Mischerausgangs mit Hilfe eines Reglers in ein vom Signalstrom abhängiges Spannungssignal umgewandelt wird und nachfolgend das Spannungssignal mit Hilfe eines Spannungs/Strom-Wandlers in mindestens ein vom Spannungssignal abhängiges Stromsignal umgewandelt wird, wobei das mindestens eine Stromsignal zum Signalstrom invertiert ist und wobei eines der Stromsignale zusammen mit dem Signalstrom eines zweiten Mischerausgangs auf einen ersten Summationspunkt gegeben wird.

2. Verfahren nach Anspruch 1, **dadurch gekennzeichnet, daß** die Eingangssignale des Mischers elektrische Signale sind.

3. Verfahren nach Anspruch 1, **dadurch gekennzeichnet, daß** mindestens eines der Eingangssignale des Mischers ein elektrisches Signal ist, während mindestens ein anderes Eingangssignal des Mischers eine elektromagnetische Welle ist.

4. Verfahren nach Anspruch 3, **dadurch gekennzeichnet, daß** der Mischer ein Photomischdetektor ist.

5. Verfahren nach einem der Ansprüche 1 bis 4, **dadurch gekennzeichnet, daß** die Ausleseelektroden des Mischers als Dioden ausgebildet sind.

6. Verfahren nach einem der Ansprüche 1 bis 5, **dadurch gekennzeichnet, daß** der Signalstrom eines ersten Mischerausgangs gemessen wird.

7. Verfahren nach Anspruch 1, **dadurch gekennzeichnet, daß** eines der beiden Stromsignale aufintegriert wird.

8. Verfahren nach Anspruch 1 oder 7, **dadurch gekennzeichnet, daß** der Regler durch eine an seinem Spannungseingang anliegende Spannung gesteuert wird.

9. Verfahren nach einem der Ansprüche 1 bis 8, **dadurch gekennzeichnet, daß** die Kennlinie des Spannungs/Strom-Wandlers über einen Steuereingang geregelt wird.

10. Verfahren nach einem der Ansprüche 1 bis 9, **dadurch gekennzeichnet, daß** der invertierte Signalstrom des ersten Mischerausgangs und der Signalstrom des ersten Mischerausgangs den gleichen Betrag haben.

11. Verfahren nach einem der Ansprüche 1 bis 10, **dadurch gekennzeichnet, daß** die Differenz der Ströme zu einem Spannungssignal aufintegriert wird.

12. Verfahren nach einem der Ansprüche 1 bis 11, **dadurch gekennzeichnet, daß** zusätzlich die Summe der Signalströme der beiden Mischerausgänge gebildet wird.

13. Verfahren nach einem der Ansprüche 1 bis 12, **dadurch gekennzeichnet, daß** die Signalströme des ersten und des zweiten Mischerausgangs repliziert werden und jeweils einer der beiden Signalströme der beiden Mischerausgänge auf einen zweiten Summationspunkt gegeben werden.

14. Verfahren nach Anspruch 12 oder 13, **dadurch gekennzeichnet, daß** das addierte Stromsignal zu einem Spannungssignal aufintegriert wird.

15. Elektronische Schaltung mit eine Mischer, zur Verarbeitung mindestens zweier zumindest teilweise korrelierter Ausgangs-Signalströme des Mischers, wobei der Mischer mindestens zwei Signaleingänge und mindestens zwei elektrische Signalausgänge aufweist, **dadurch gekennzeichnet, daß** die Schaltung eine Einrichtung zur instantanen Bildung der Differenz zwischen den Signalströmen von jeweils zwei Mischerausgängen mit einem Invertierer für einen Signalstrom eines ersten Mischerausgangs aufweist, wobei der Invertierer einen Regler zum Umwandeln des Signalstroms des ersten Mischerausgangs in ein vom Signalstrom abhängiges Spannungssignal und einen Spannungs/Strom-Wandler zum Umwandeln des Spannungssignals in mindestens ein vom Spannungssignal abhängiges Stromsignal aufweist, wobei das mindestens eine Stromsignal zum Signalstrom invertiert ist und wobei der Ausgang des Invertierers und ein zweiter Mischerausgang mit einem ersten Summationspunkt verbunden sind.

16. Elektronische Schaltung nach Anspruch 15, **dadurch gekennzeichnet, daß** die Eingangssignale des Mischers elektrische Signale sind.

17. Elektronische Schaltung nach Anspruch 15, **dadurch gekennzeichnet, daß** mindestens eines der Eingangssignale des Mischers ein elektrisches Signal ist, während mindestens ein anderes Eingangssignal des Mischers eine elektromagnetische Welle ist.

18. Elektronische Schaltung nach Anspruch 17, **dadurch gekennzeichnet, daß** der Mischer ein Photomischdetektor ist.

19. Elektronische Schaltung nach einem der Ansprüche 15 bis 18, **dadurch gekennzeichnet, daß** die Ausleseelektroden des Mischers als Dioden ausgebildet sind.

20. Elektronische Schaltung nach einem der Ansprüche 15 bis 19, **dadurch gekennzeichnet, daß** eine Einrichtung zum Messen des Signalstroms eines ersten Mischerausgangs vorgesehen ist.

21. Elektronische Schaltung nach Anspruch 15, **dadurch gekennzeichnet, daß** der Regler durch eine an seinem Spannungseingang anliegende Spannung steuerbar ist.

22. Elektronische Schaltung nach Anspruch 15 oder 21, **dadurch gekennzeichnet, daß** die Kennlinie des Spannungs/Strom-Wandlers über einen Steuereingang regelbar ist.

23. Elektronische Schaltung nach einem der Ansprüche 15 bis 22, **dadurch gekennzeichnet, daß** sie eine Einrichtung zum Aufintegrieren eines der vom Spannungssignal abhängigen Stromsignale aufweist.

24. Elektronische Schaltung nach einem der Ansprüche 15 bis 23, **dadurch gekennzeichnet, daß** der Signalstrom des ersten Mischerausgangs und der invertierte Signalstrom des ersten Mischerausgangs den gleichen Betrag haben.

25. Elektronische Schaltung nach einem der Ansprüche 15 bis 24, **dadurch gekennzeichnet, daß** sie eine Einrichtung zum Aufintegrieren der Differenz der Ströme zu einem Spannungssignal aufweist, welche mit dem ersten Summationspunkt verbunden ist.

26. Elektronische Schaltung nach einem der Ansprüche 15 bis 25, **dadurch gekennzeichnet, daß** zusätzlich eine Einrichtung zum Summieren der Signalströme der beiden Mischerausgänge vorgesehen ist.

27. Elektronische Schaltung nach einem der Ansprüche 15 bis 26, **dadurch gekennzeichnet, daß** jeweils ein Replikator für die Signalströme der beiden Mischerausgänge vorgesehen ist und jeweils einer der Ausgänge der Replikatoren mit einem zweiten Summationspunkt verbunden ist.

28. Elektronische Schaltung nach Anspruch 26 oder 27, **dadurch gekennzeichnet, daß** eine Einrichtung zum Integrieren des Summensignals vorgesehen ist.

29. Elektronische Schaltung nach einem der Ansprüche 15 bis 28, **dadurch gekennzeichnet, daß** die Schaltung zur Verarbeitung mindestens zweier zumindest teilweise korrelierter Ausgangssignalströme eines Mischers ein integrierter Schaltkreis ist.

30. Elektronische Schaltung nach einem der Ansprüche 15 bis 29, **dadurch gekennzeichnet, daß** auf einem integrierten Schaltkreis mindestens eine Schaltung zur Verarbeitung mindestens zweier zumindest teilweise korrelierter Ausgangssignalströme eines Mischers und mindestens ein Mischer integriert sind.

31. Elektronische Schaltung nach einem der Ansprüche 15 bis 30, **dadurch gekennzeichnet, daß** sie zur Ausführung des Verfahrens nach Anspruch 1 bis 14 geeignet ist.

## Claims

1. A method of processing at least two at least partially correlated output signal streams of a mixer, the mixer having at least two signal inputs and at least two electric signal outputs, **characterised in that** the difference in the signal streams of the outputs of the mixer is formed in pairwise relationship directly and during reading-out of the signal streams, wherein the signal stream of a first mixer output is converted by means of a regulator into a voltage signal dependent on the signal stream and subsequently the voltage signal is converted by means of a voltage/current converter into at least one current signal dependent on the voltage signal, wherein the least one current signal is inverted in relation to the signal stream and wherein one of the current signals is passed together with the signal stream of a second mixer output to a first summation point.

2. A method according to claim 1 **characterised in that** the input signals of the mixer are electric signals

3. A method according to claim 1 **characterised in that** at least one of the input signals of the mixer is an electric signal while at least one other input signal of the mixer is an electromagnetic wave.

4. A method according to claim 3 **characterised in that** the mixer is a photonic mixer device.

5. A method according to one of claims 1 to 4 **characterised in that** the reading-out electrodes of the mixer are in the form of diodes.

6. A method according to one of claims 1 to 5 **characterised in that** the signal stream of a first mixer output is measured.

7. A method according to claim 1 **characterised in that** one of the two current signals is integrated.

8. A method according to claim 1 or or claim 7 **characterised in that** the regulator is controlled by a voltage applied to its voltage input.

9. A method according to one of claims 1 to 8 **characterised in that** the characteristic of the voltage/current converter is regulated by way of a control input.

10. A method according to one of claims 1 to 9 **characterised in that** the inverted signal stream of the first mixer output and the signal stream of the first mixer output are of the same magnitude.

11. A method according to one of claims 1 to 10 **characterised in that** the difference in the currents is integrated to form a voltage signal.

12. A method according to one of claims 1 to 11 **characterised in that** in addition the sum of the signal streams of the two mixer outputs is formed.

13. A method according to one of claims 1 to 12 **characterised in that** the signal streams of the first and the second mixer outputs are replicated and a respective one of the two signal streams of the two mixer outputs is passed to a second summation point.

14. A method according to claim 12 or claim 13, **characterised in that** the added current signal is integrated to form a voltage signal.

15. An electronic circuit having a mixer for processing at least two at least partially correlated output signal streams of the mixer, wherein the mixer has at least two signal inputs and at least two electric signal outputs, **characterised in that** the circuit has a device for the instantaneous formation of the difference between the signal streams of two respective mixer outputs, comprising an inverter for a signal stream of a first mixer output, wherein the inverter has a regulator for converting the signal stream of the first mixer output into a voltage signal dependent on the signal stream and a voltage/current converter for converting the voltage signal into at least one current signal dependent on the voltage signal, wherein the at least one current signal is inverted in relation to the signal stream, and wherein the output of the inverter and a second mixer output are connected to a first summation point.

16. An electronic circuit according to claim 15 **characterised in that** the input signals of the mixer are electric signals.

17. An electronic circuit according to claim 15 **characterised in that** at least one of the input signals of the mixer is an electric signal while at least one other input signal of the mixer is an electromagnetic wave.

18. An electronic circuit according to claim 17 **characterised in that** the mixer is a photonic mixer device.

19. An electronic circuit according to one of claims 15 to 18 **characterised in that** the reading-out electrodes of the mixer are in the form of diodes.

20. An electronic circuit according to one of claims 15 to 19 **characterised in** there is provided a device for measuring the signal stream of a first mixer output.

21. An electronic circuit according to claim 15 **characterised in that** the regulator is controllable by a voltage applied to its voltage input.

22. An electronic circuit according to claim 15 or claim 21 **characterised in that** the characteristic of the voltage/current converter is regulatable by way of a control input.

23. An electronic circuit according to one of claims 15 to 22 **characterised in that** it has a device for integrating one of the current signals dependent on the voltage signal.

24. An electronic circuit according to one of claims 15 to 23 **characterised in that** the signal stream of the first mixer output and the inverted signal stream of the first mixer output are of the same magnitude.

25. An electronic circuit according to one of claims 15 to 24 **characterised in that** it has a device for integrating the difference in the currents to form a voltage signal, which is connected to the first summation point.

26. An electronic circuit according to one of claims 15 to 25 **characterised in that** there is additionally provided a device for summing the signal streams of the two mixer outputs.

27. An electronic circuit according to one of claims 15 to 26 **characterised in that** there is provided a respective replicator for the signal streams of the two mixer outputs and a respective one of the outputs of the replicators is connected to a second summation point.

28. An electronic circuit according to claim 26 or claim 27 **characterised in that** there is provided a device for integrating the summing signal.

29. An electronic circuit according to one of claims 15 to 28 **characterised in that** the circuit for processing at least two at least partially correlated output signal streams of a mixer is an integrated circuit.

30. An electronic circuit according to one of claims 15 to 29 **characterised in that** at least one circuit for processing at least two at least partially correlated output signal streams of a mixer and at least one mixer are integrated on an integrated circuit.

31. An electronic circuit according to one of claims 15 to 30 **characterised in that** it is suitable for carrying out the method according to claims 1 to 14.

## Revendications

1. Procédé de traitement d'au moins deux flux de signaux de sortie, au moins en partie corrélés, d'un mélangeur, dans lequel le mélangeur comprend au moins deux entrées de signaux et au moins deux sorties de signaux électriques, **caractérisé en ce que** la différence des flux de signaux des sorties du mélangeur est formée directement par paires et durant la lecture des flux de signaux, où le flux de signaux d'une première sortie du mélangeur est converti à l'aide d'un régulateur en un signal de tension dépendant du flux de signaux, et où ensuite le signal de tension est converti à l'aide d'un convertisseur tension-courant en au moins un signal de courant dépendant du signal de tension, le signal de courant, au moins au nombre de un, étant inversé par rapport au flux de signaux, et un des signaux de courant étant fourni conjointement au flux de signaux d'une deuxième sortie du mélangeur en un premier point de sommation.

2. Procédé selon la revendication 1, **caractérisé en ce que** les signaux d'entrée du mélangeur sont des signaux électriques.

3. Procédé selon la revendication 1, **caractérisé en ce qu'**au moins un des signaux d'entrée du mélangeur est un signal électrique tandis qu'au moins un autre signal d'entrée du mélangeur est une onde électromagnétique.

4. Procédé selon la revendication 3, **caractérisé en ce que** le mélangeur est un détecteur mélangeur photonique.

5. Procédé selon l'une des revendications 1 à 4, **caractérisé en ce que** les électrodes de lecture du mélangeur sont conçues en tant que diodes.

6. Procédé selon l'une des revendications 1 à 5, **caractérisé en ce que** le flux de signaux d'une première sortie du mélangeur est mesuré.

7. Procédé selon la revendication 1, **caractérisé en ce qu'**un des deux signaux de courant est soumis à une intégration.

8. Procédé selon la revendication 1 ou 7, **caractérisé en ce que** le régulateur est commandé par une tension appliquée sur son entrée de tension.

9. Procédé selon l'une des revendications 1 à 8, **caractérisé en ce que** la courbe caractéristique du convertisseur tension-courant est régulée par le biais d'une entrée de commande.

10. Procédé selon l'une des revendications 1 à 9, **caractérisé en ce que** le flux de signaux inversé de la première sortie du mélangeur et le flux de signaux de la première sortie du mélangeur ont la même valeur absolue.

11. Procédé selon l'une des revendications 1 à 10, **caractérisé en ce que** la différence des courants est intégrée pour former un signal de tension.

12. Procédé selon l'une des revendications 1 à 11, **caractérisé en ce qu'**est en outre formée la somme des flux de signaux des deux sorties du mélangeur.

13. Procédé selon l'une des revendications 1 à 12, **caractérisé en ce que** les flux de signaux de la première et de la deuxième sortie du mélangeur sont répliqués et que chacun des deux flux de signaux des deux sorties du mélangeur sont disponibles sur un deuxième point de sommation.

14. Procédé selon la revendication 12 ou 13, **caractérisé en ce que** le signal de courant additionné est intégré en un signal de tension.

15. Circuit électronique comportant un mélangeur destiné au traitement d'au moins deux flux de signaux de sortie du mélangeur, au moins en partie corrélés, dans lequel le mélangeur comprend au moins deux entrées de signaux et au moins deux sorties de signaux électriques, **caractérisé en ce que** le circuit comprend un dispositif de formation instantanée de la différence entre les flux de signaux de chacune des deux sorties du mélangeur, comportant un inverseur pour un flux de signaux d'une première sortie du mélangeur, où l'inverseur comprend un régulateur destiné à convertir le flux de signaux de la première sortie du mélangeur en un signal de tension dépendant du flux de signaux et un convertisseur tension-courant destiné à convertir le signal de tension en au moins un signal de courant dépendant du signal de tension, le signal de courant, au moins au nombre de un, étant inversé par rapport au flux de signaux, et la sortie de l'inverseur et une deuxième sortie du mélangeur étant reliées à un premier point de sommation.

16. Circuit électronique selon la revendication 15, **caractérisé en ce que** les signaux d'entrée du mélangeur sont des signaux électriques.

17. Circuit électronique selon la revendication 15, **caractérisé en ce qu'**au moins un des signaux d'entrée du mélangeur est un signal électrique tandis qu'au moins un autre signal d'entrée du mélangeur est une onde électromagnétique.

18. Circuit électronique selon la revendication 17, **caractérisé en ce que** le mélangeur est un détecteur mélangeur photonique.

19. Circuit électronique selon l'une des revendications 15 à 18, **caractérisé en ce que** les électrodes de lecture du mélangeur sont conçues en tant que diodes.

20. Circuit électronique selon l'une des revendications 15 à 19, **caractérisé en ce qu'**il est prévu un dispositif pour mesurer le flux de signaux d'une première sortie du mélangeur.

21. Circuit électronique selon la revendication 15, **caractérisé en ce que** le régulateur peut être commandé par une tension appliquée sur son entrée de tension.

22. Circuit électronique selon la revendication 15 ou 21, **caractérisé en ce que** la courbe caractéristique du convertisseur tension-courant peut être régulée par le biais d'une entrée de commande.

23. Circuit électronique selon l'une des revendications 15 à 22, **caractérisé en ce qu'**il comprend un dispositif d'intégration d'un des signaux de courant dépendant du signal de tension.

24. Circuit électronique selon l'une des revendications 15 à 23, **caractérisé en ce que** le flux de signaux de la première sortie du mélangeur et le flux de signaux inversé de la première sortie du mélangeur ont la même valeur absolue.

25. Circuit électronique selon l'une des revendications 15 à 24, **caractérisé en ce qu'**il comprend un dispositif d'intégration de la différence des courants en un signal de tension qui est relié au premier point de sommation.

26. Circuit électronique selon l'une des revendications 15 à 25, **caractérisé en ce qu'**il est prévu en plus un dispositif de sommation des flux de signaux des deux sorties du mélangeur.

27. Circuit électronique selon l'une des revendications 15 à 26, **caractérisé en ce qu'**il est prévu respectivement un réplicateur pour les flux de signaux des deux sorties du mélangeur et qu'une des sorties des réplicateurs est respectivement reliée à un deuxième point de sommation.

28. Circuit électronique selon la revendication 26 ou 27, **caractérisé en ce qu'**il est prévu un dispositif pour intégrer des signaux de somme.

29. Circuit électronique selon l'une des revendications 15 à 28, **caractérisé en ce que** le circuit destiné au traitement d'au moins deux flux de signaux de sortie, au moins en partie corrélés, d'un mélangeur est un circuit intégré.

30. Circuit électronique selon l'une quelconque des revendications 15 à 29, **caractérisé en ce que**, sur un circuit intégré, sont intégrés au moins un circuit de traitement d'au moins deux flux de signaux de sortie, au moins en partie corrélés, d'un mélangeur, et au moins un mélangeur.

31. Circuit électronique selon l'une des revendications 15 à 30, **caractérisé en ce qu'**il est approprié pour l'exécution du procédé selon la revendication 1 à 14.
